# EUROPEAN PATENT SPECIFICATION

(11) **EP 3 037 976 B1**
(45) Date of publication and mention of the grant of the patent: **03.01.2018**
(21) Application number: 15195491.4
(22) Date of filing: 19.11.2015
(51) Int. Cl.: G06F 13/42

(54) **ENHANCED DATA BUS INVERT ENCODING FOR OR CHAINED BUSES**
VERBESSERTE DATENBUS-INVERTCODIERUNG FÜR VERKETTETE BUSSE
CODAGE D'INVERSION DE BUS DE DONNÉES AMÉLIORÉ POUR DES BUS EN CHAÎNE

(30) Priority: 15.12.2014 US 201414569985
(43) Date of publication of application: 29.06.2016
(73) Proprietor: Intel Corporation, Santa Clara, CA 95054 (US)
(72) Inventor: KWON, Kon-Woo, Hillsboro, OR 97124 (US); SOMASEKHAR, Dinesh, Portland, OR 97229 (US); PARK, Sang Phill, Hillboro, OR 97124 (US)
(74) Representative: HGF Limited

(56) References cited:
- WO-A2-2011/008394
- US-A- 5 654 927
- US-A1- 2013 159 584
- US-A1- 2014 215 140

## Description

### FIELD

The present disclosure generally relates to the field of electronics. More particularly, an embodiment relates to enhanced data bus invert encoding for OR chained buses.
International patent publication number WO 2011/008394 A2 describes a data encoding scheme for transmission of data from one circuit to another circuit by combining Data Bus Inversion (DBI) encoding and non-DBI encoding. A data mask signal is used to indicate the type of encoding used.

### BRIEF DESCRIPTION OF THE DRAWINGS

The detailed description is provided with reference to the accompanying figures. In the figures, the left-most digit(s) of a reference number identifies the figure in which the reference number first appears. The use of the same reference numbers in different figures indicates similar or identical items.
Fig. 1 illustrates a block diagram of an embodiment of a computing systems, which can be utilized to implement various embodiments discussed herein.
Fig. 2 illustrates a block diagram of an embodiment of a computing system, which can be utilized to implement one or more embodiments discussed herein.
Fig. 3A illustrates a 4-bit bus data transmission with data parking, where Data Bus Invert (DBI) encoding increases data transmission activity.
Fig. 3B illustrates a 4-bit bus data transmission with data parking, where Weight Coding (WC) encoding increases data transmission activity.
Fig. 4 illustrates a block diagram of an Enhanced Data Bus Invert (EDBI) encoder, according to an embodiment.
Fig. 5 illustrates a flow diagram of a method to provide EDBI encoding, in accordance with an embodiment.
Fig. 6 illustrates an EDBI decision block, according to an embodiment.
Fig. 7 illustrates a block diagram of an embodiment of a computing system, which can be utilized to implement one or more embodiments discussed herein.
Fig. 8 illustrates a block diagram of an embodiment of a computing system, which can be utilized to implement one or more embodiments discussed herein.
Fig. 9 illustrates a block diagram of an System On Chip (SOC) package in accordance with an embodiment.

### DETAILED DESCRIPTION

In the following description, numerous specific details are set forth in order to provide a thorough understanding of various embodiments. However, some embodiments may be practiced without the specific details. In other instances, well-known methods, procedures, components, and circuits have not been described in detail so as not to obscure the particular embodiments. Various aspects of embodiments may be performed using various means, such as integrated semiconductor circuits ("hardware"), computer-readable instructions organized into one or more programs ("software") or some combination of hardware and software. For the purposes of this disclosure reference to "logic" shall mean either hardware, software, or some combination thereof.

Generally, for systems with relatively wide buses (e.g., emphasizing data transmission), a large amount of energy is dissipated owing to charging and discharging of the bus capacitances (for data transition activity). Switching activity on the bus can occur due to (1) data values changing; and/or (2) the data bus transitioning from a valid to a "parked" state. A "parked" state generally refers to a state in which a bus has a deterministic state, e.g., to facilitate subsequent operations more quickly and/or accurately. For example, some implementations may use complex multiplexers when combining (OR chaining) two buses. However, if the state of a bus is parked, the output of the control gate can be read deterministically (e.g., where one of the inputs is always 1 or 0). Also, parking the state reduces the amount of hardware associated with complex multiplexers (which in turn reduces costs, power consumption, and/or delay). Further, lack of complex multiplexers provides an easier control solution since control signals for the multiplexers are no longer present. Previous solutions generally do not consider the "parked" state when combining buses; and, hence, can increase switching activity which in turn results in more power consumption, costs, delays, etc.

To this end, some embodiments provide enhanced Data Bus Invert (EDBI) encoding for "OR" (i.e., logic OR) chained buses. As discussed herein, the term "bus" can be interchangeably referred to as "interconnect." As discussed herein, EDBI encoding can reduce the switching activity of data buses (e.g., with multiple senders on each bus) when bus parking is used. In an embodiment, incoming data on a bus (e.g., originating from a plurality of sources/buses) is encoded based at least in part on a determination of whether a next data value on the bus is going to transitioning from a valid value to a parked state.

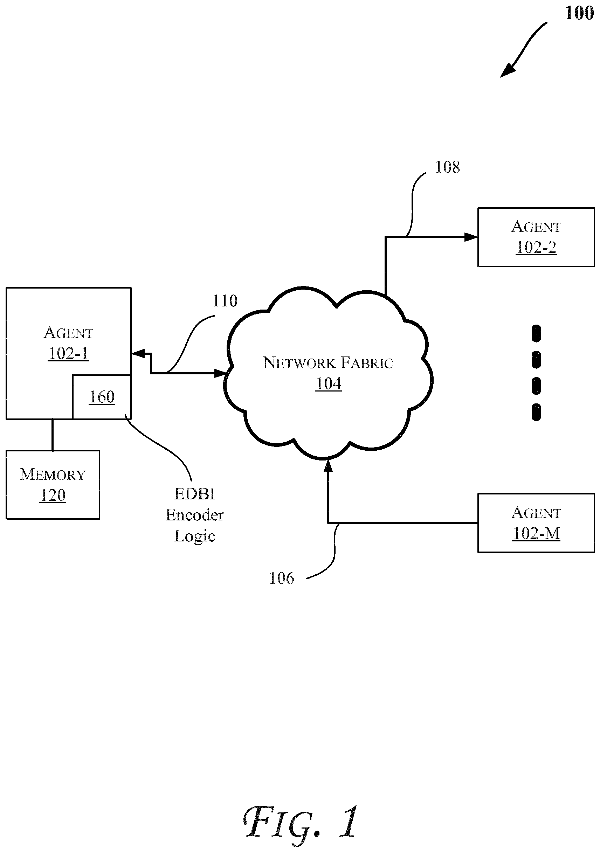

Moreover, the techniques discussed herein can be utilized in various computing systems (e.g., a non-mobile device such as a desktop computer, a server, a work station, etc., as well as a mobile device such as a smartphone, tablet, UMPC (Ultra-Mobile Personal Computer), laptop computer, Ultrabook™ computing device, wearable devices (such as smart watches, smart glasses), etc.), including those discussed with reference to Figs. 1-9. More particularly, Fig 1 illustrates a block diagram of a computing system 100, according to an embodiment. The system 100 includes one or more agents 102-1 through 102-M (collectively referred to herein as "agents 102" or more generally "agent 102"). In an embodiment, one or more of the agents 102 are components of a computing system, such as the computing systems discussed with reference to Figs. 1-9.

As illustrated in Fig. 1, the agents 102 communicate via a network fabric 104. In one embodiment, the network fabric 104 includes a computer network that allows various agents (such as computing devices) to communicate data. In an embodiment, the network fabric 104 includes one or more interconnects (or interconnection networks) that communicate via a serial (e.g., point-to-point) link and/or a shared communication network (which is be configured as a ring in an embodiment). Each link may include one or more lanes. For example, some embodiments facilitate component debug or validation on links that allow communication with Fully Buffered Dual in-line memory modules (FBD), e.g., where the FBD link is a serial link for coupling memory modules to a host controller device (such as a processor or memory hub). Debug information is transmitted from the FBD channel host such that the debug information is observed along the channel by channel traffic trace capture tools (such as one or more logic analyzers).

In one embodiment, the system 100 supports a layered protocol scheme, which includes a physical layer, a link layer, a routing layer, a transport layer, and/or a protocol layer. The fabric 104 further facilitates transmission of data (e.g., in form of packets) from one protocol (e.g., caching processor or caching aware memory controller) to another protocol for a point-to-point or shared network. Also, in some embodiments, the network fabric 104 provides communication that adheres to one or more cache coherent protocols.

Furthermore, as shown by the direction of arrows in Fig. 1, the agents 102 can transmit and/or receive data via the network fabric 104. Hence, some agents utilize a unidirectional link, while others utilize a bidirectional link for communication. For instance, one or more agents (such as agent 102-M) transmit data (e.g., via a unidirectional link 106), other agent(s) (such as agent 102-2) receive data (e.g., via a unidirectional link 108), while some agent(s) (such as agent 102-1) both transmit and receive data (e.g., via a bidirectional link 110).

Additionally, at least one of the agents 102 is a home agent and one or more of the agents 102 are requesting or caching agents. Generally, requesting/caching agents send request(s) to a home node/agent for access to a memory address with which a corresponding "home agent" is associated. Further, in an embodiment, one or more of the agents 102 (only one shown for agent 102-1) have access to a memory (which can be dedicated to the agent or shared with other agents) such as memory 120. In some embodiments, each (or at least one) of the agents 102 is coupled to the memory 120 that is either on the same die as the agent or otherwise accessible by the agent. Also, as shown in Fig. 1, agents 102 include EDBI encoder logic 160 to support EDBI encoding operations for OR chained buses, as discussed herein.

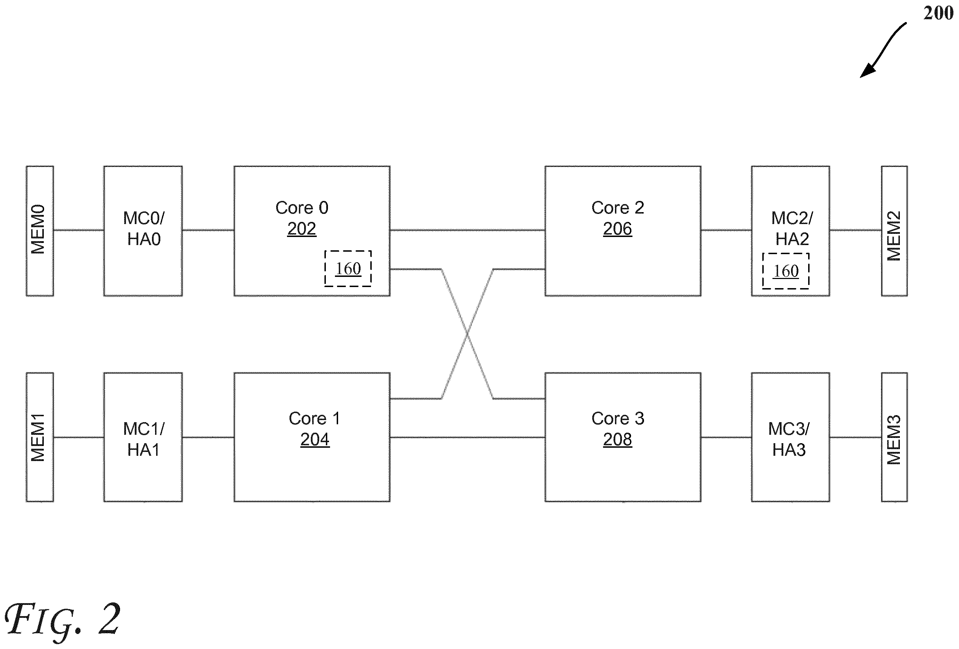

Fig. 2 is a block diagram of a computing system 200 in accordance with an embodiment. System 200 includes a plurality of sockets 202-208 (four shown but some embodiments can have more or less socket). Each socket includes a processor. Also, various agents in the system 200 can include logic 160. Even though logic 160 is only shown in items 202 and MC2/HA2, logic 160 may be provided in other agents of system 200. Further, more or less logic blocks can be present in a system depending on the implementation. Additionally, each socket is coupled to the other sockets via a point-to-point (PtP) link, or a differential interconnect, such as a Quick Path Interconnect (QPI), MIPI (Mobile Industry Processor Interface), etc. As discussed with respect the network fabric 104 of Fig. 1, each socket is coupled to a local portion of system memory, e.g., formed by a plurality of Dual Inline Memory Modules (DIMMs) that include dynamic random access memory (DRAM).

In another embodiment, the network fabric is utilized for any System on Chip (SoC or SOC) application, utilize custom or standard interfaces, such as, ARM compliant interfaces for AMBA (Advanced Microcontroller Bus Architecture), OCP (Open Core Protocol), MIPI (Mobile Industry Processor Interface), PCI (Peripheral Component Interconnect) or PCIe (Peripheral Component Interconnect express).

Some embodiments use a technique that enables use of heterogeneous resources, such as AXI/OCP technologies, in a PC (Personal Computer) based system such as a PCI-based system without making any changes to the IP resources themselves. Embodiments provide two very thin hardware blocks, referred to herein as a Yunit and a shim, that can be used to plug AXI/OCP IP into an auto-generated interconnect fabric to create PCI-compatible systems. In one embodiment, a first (e.g., a north) interface of the Yunit connects to an adapter block that interfaces to a PCI-compatible bus such as a direct media interface (DMI) bus, a PCI bus, or a Peripheral Component Interconnect Express (PCIe) bus. A second (e.g., south) interface connects directly to a non-PC interconnect, such as an AXI/OCP interconnect. In various implementations, this bus may be an OCP bus.

In some embodiments, the Yunit implements PCI enumeration by translating PCI configuration cycles into transactions that the target IP can understand. This unit also performs address translation from re-locatable PCI addresses into fixed AXI/OCP addresses and vice versa. The Yunit may further implement an ordering mechanism to satisfy a producer-consumer model (e.g., a PCI producer-consumer model). In turn, individual IPs are connected to the interconnect via dedicated PCI shims. Each shim may implement the entire PCI header for the corresponding IP. The Yunit routes all accesses to the PCI header and the device memory space to the shim. The shim consumes all header read/write transactions and passes on other transactions to the IP. In some embodiments, the shim also implements all power management related features for the IP.

Thus, rather than being a monolithic compatibility block, embodiments that implement a Yunit take a distributed approach. Functionality that is common across all IPs, e.g., address translation and ordering, is implemented in the Yunit, while IP-specific functionality such as power management, error handling, and so forth, is implemented in the shims that are tailored to that IP.

In this way, a new IP can be added with minimal changes to the Yunit. For example, in one implementation the changes may occur by adding a new entry in an address redirection table. While the shims are IP-specific, in some implementations a large amount of the functionality (e.g., more than 90%) is common across all IPs. This enables a rapid reconfiguration of an existing shim for a new IP. Some embodiments thus also enable use of auto-generated interconnect fabrics without modification. In a point-to-point bus architecture, designing interconnect fabrics can be a challenging task. The Yunit approach described above leverages an industry ecosystem into a PCI system with minimal effort and without requiring any modifications to industry-standard tools.

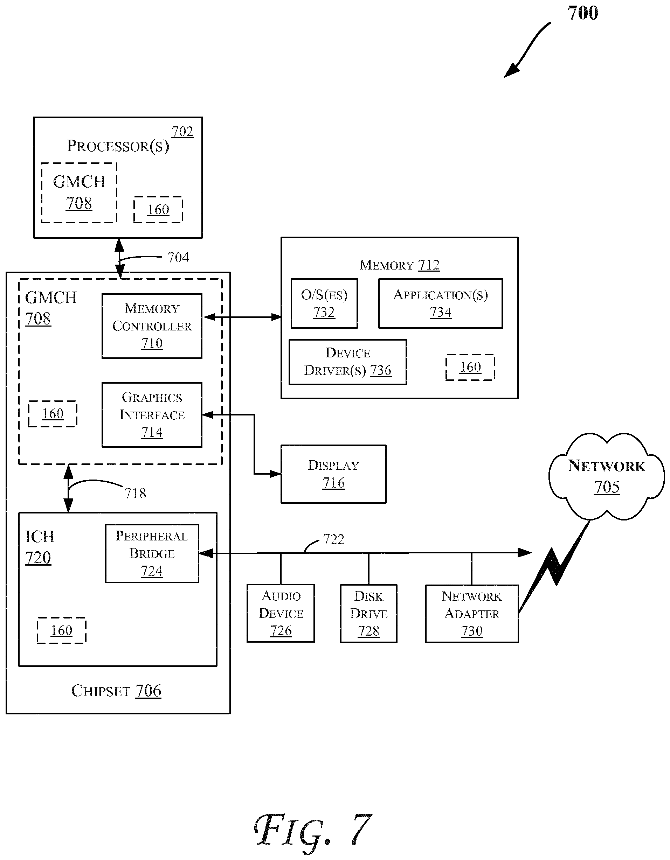

As shown in Fig. 2, each socket is coupled to a Memory Controller (MC)/Home Agent (HA) (such as MC0/HA0 through MC3/HA3). The memory controllers are coupled to a corresponding local memory (labeled as MEM0 through MEM3), which can be a portion of system memory (such as memory 712 of Fig. 7). In some embodiments, the memory controller (MC)/Home Agent (HA) (such as MC0/HA0 through MC3/HA3) can be the same or similar to agent 102-1 of Fig. 1 and the memory, labeled as MEM0 through MEM3, can be the same or similar to memory devices discussed with reference to any of the figures herein. Also, in one embodiment, MEM0 through MEM3 can be configured to mirror data, e.g., as master and slave. Also, one or more components of system 200 can be included on the same integrated circuit die in some embodiments.

Furthermore, at least one implementation (such as shown in Fig. 2) can be used for a socket glueless configuration with mirroring. For example, data assigned to a memory controller (such as MC0/HA0) is mirrored to another memory controller (such as MC3/HA3) over the PtP links.

Some solutions for combining buses may include:
(1) Data Bus Invert (DBI) which is bus encoding scheme with one extra wire. DBI computes the Hamming Distance (D_{H}) between the present bus value and the next data value to transmit. If D_{H} is greater than half of the bus width, the extra wire value is set as logical '1' and the next bus values are set as the inverted next data value. Otherwise, the extra wire is set as logical '0' and the next bus values are set as equal to the next data value; and
(2) Weight Coding (WC) calculates the number of logical '1's on the next data value. If the calculated number is greater than half of the bus width, the next bus values are set as the inverted data value. The WC may also use an extra wire to indicate whether the bus values are inverted.

In one embodiment, EDBI encoder logic 160 functions based on the following: (a) EDBI logic 160 determines whether the next data value will go from a valid to a "parked" state. If so, EDBI logic considers both (1) D_{H} between the present bus value and the next data value to transmit; and (2) the weight (W) of the next data value to determine toggling of bit values on the bus; and (b) otherwise, EDBI logic 160 performs similarly to DBI coding.

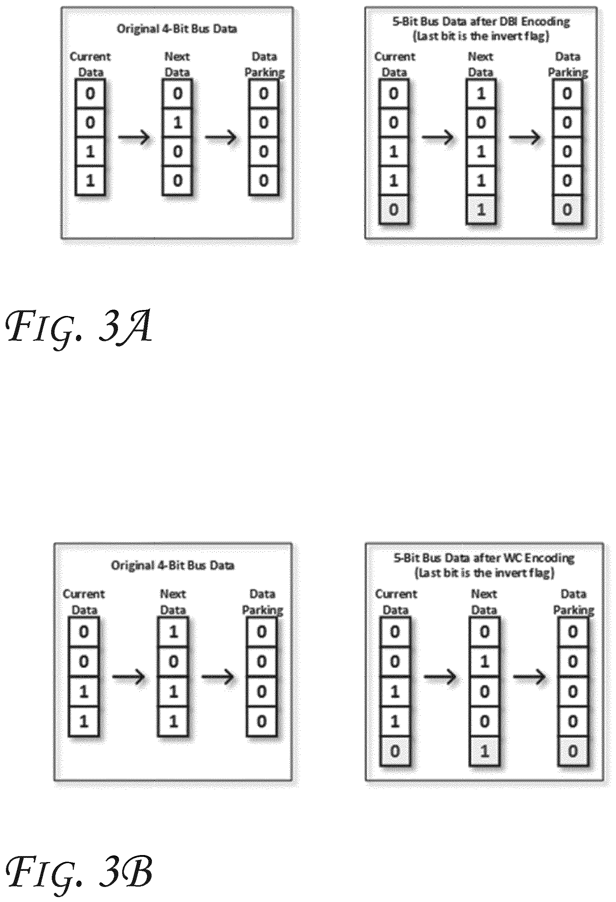

For buses which collect data from multiple sources (e.g., using an OR tree), data parking is performed at the end of data transmission. For example, multiple banks of memory may be coupled together by OR trees (e.g., in a chain with outputs of each pair of memory banks being combined with a logic OR gate and fed to the next stage to be logically OR with the output of the next memory bank in the chain). In such an example (e.g., providing data parking with all zero values), and where the data parking is performed at the end of data transmission, previous bus encoding schemes such as DBI or WC encoding can increase the data transition activity, as shown in Figs. 3A and 3B, respectively. More particularly, Fig. 3A shows how DBI encoding increases the number of bit transitions from 4 to 6 and Fig. 3B illustrates how WC encoding increases the number of bit transitions from 4 to 6. By contrast, EDBI may guarantee that its encoding technique reduces (or maintains) the level of data transition activity for any data bus values even when the data parking is requested.

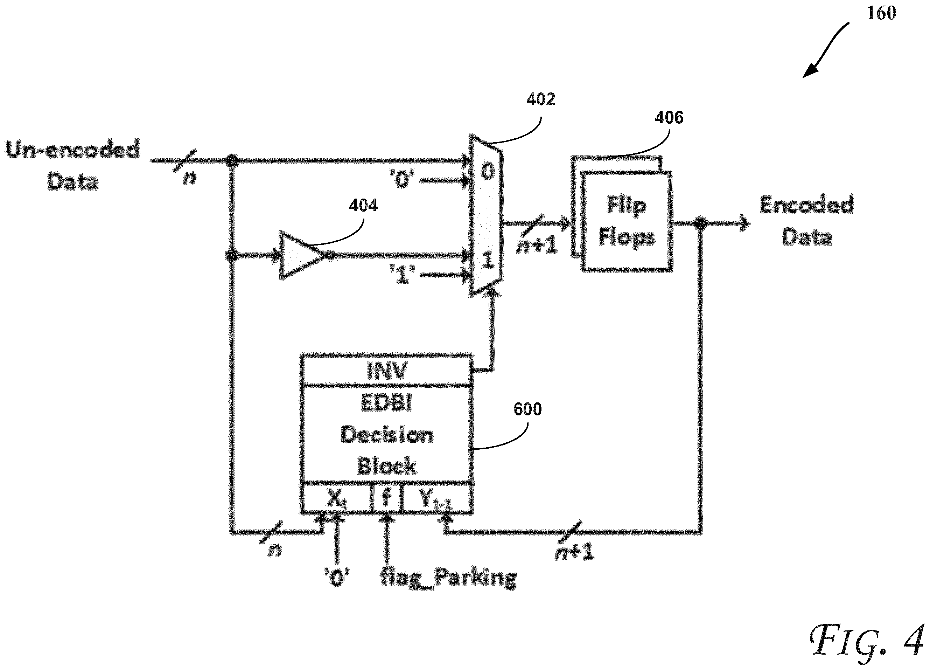

Fig. 4 illustrates a block diagram of an Enhanced Data Bus Invert (EDBI) encoder logic 160, according to an embodiment. In an embodiment, a parked state is assumed to be all zeros. Moreover, techniques discussed herein can be applied (a) to all the bits of a bus or (b) by breaking the bus into individual groups with groups being encoded separately.

As illustrated in Fig. 4, EDBI encoder logic 160 performs bus encoding with one extra wire (i.e., from n-bit un-encoded data to (n+1)-bit encoded data) which is similar to conventional DBI and WC (hence, EDBI logic does not add any extra overhead). If the next data transmission is supposed to be followed by the data parking operation, the one-bit flag (or extra wire) named "flag_Parking" is set to 1 (or another value depending on the implementation) and the EDBI decision block logic 600 considers both: (1) D_{H} between the present bus value (Yₜ₋₁) and the next data value (Xₜ); and (2) the Weight (W) of the next data value. Otherwise, EDBI decision block logic 600 operates in a similar fashion as DBI encoding in an embodiment.

Moreover, as shown in Fig. 4, the un-encoded data is fed to a multiplexer 402 (e.g., both directly as well as through an inverter 404). Logic 600 then decides which input of the multiplexer 402 is selected to be fed to flip-flops 406 and output as encoded data.

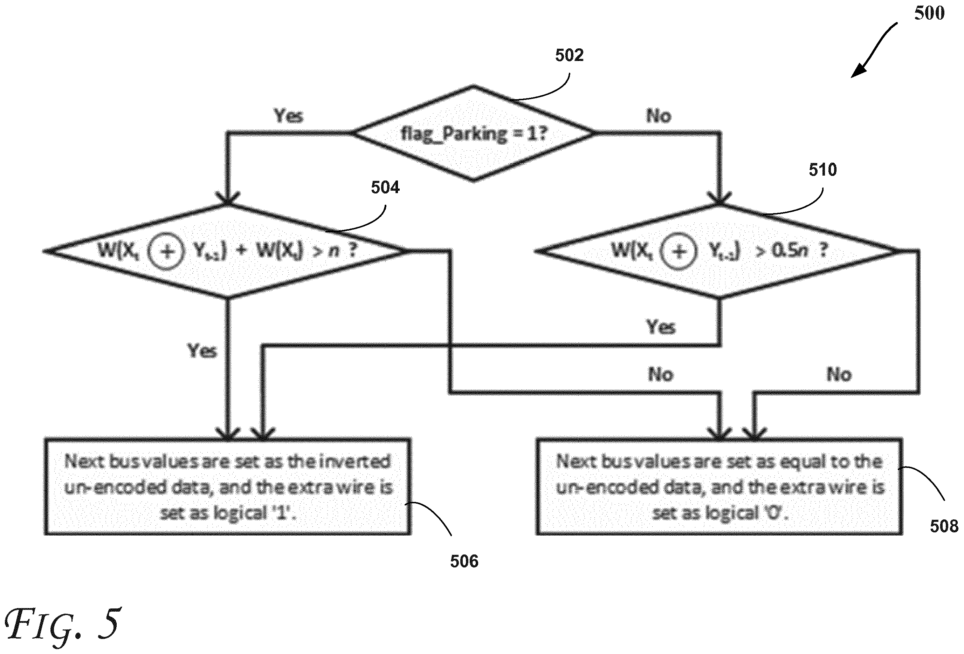

Fig. 5 illustrates a flow diagram of a method 500 to provide EDBI encoding, in accordance with an embodiment. In one embodiment, various components discussed with reference to Figs. 1-4 and 6-9 can be utilized to perform one or more of the operations discussed with reference to Fig. 5. In an embodiment, method 500 is implemented in logic, such as the EDBI encoder logic 1600 of Fig. 1.

Referring to Figs. 5, at an operation 502, it is determined whether the flag_Parking is asserted (e.g., set to '1'). If so, at operation 504 the weight of combination of the next data value (Xₜ) and the present bus value (Yₜ₋₁) (as shown logically XOR'd) plus the weight of the next data value (Xₜ) are compared to n (which is the width of the incoming bus as shown in Fig. 4). If the combination of this weights are larger than n, operation 506 picks the next bus values as the inverted un-encoded/incoming data, and the signal on the extra wire is asserted (e.g., set to logical 'l'). If the combination is not larger than n, operation 508 picks the next bus values as equal to the un-encoded/incoming data, and the signal on the extra wire is deasserted (e.g., set to logical '0'). Alternatively, if at operation 502, it is determined that the flag_Parking in deasserted (e.g., set to '0'), operation 510 determines whether the weight of the next data value (Xₜ) logically XOR'd with the present bus value (Yₜ₋₁) is larger than half of n. If so, method 500 continues with operation 506; otherwise, operation 508 is performed after operation 510.

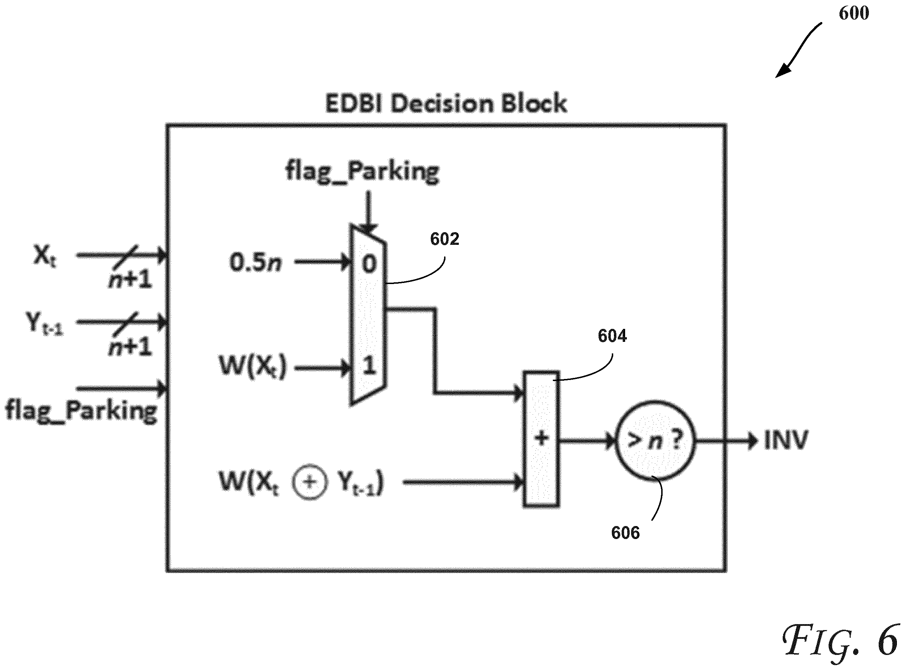

Fig. 6 illustrates an EDBI decision block logic 600, according to an embodiment. As illustrated, the EDBI decision block logic 600 includes a multiplexer 602 to select (e.g., based on the state of the flag_Parking flag) between half of the bus width (0.5n) and the weight of the next data value (Xₜ). Output of the multiplexer 602 is then combined with (i.e., added by adder 604 to) the weight of the next data value (Xₜ) logically XOR'd with the present bus value (Yₜ₋₁). Output of the adder 604 is compared with n by comparator 606 and the result is then inverted (before being fed as the select signal for the multiplexer 402 of Fig. 4) by an inverter (not shown in Fig. 6 but labeled as INV in Fig. 4, for example).

In some embodiments (e.g., assuming data senders transmit data by starting from a parked state, then send 2-burst data and return back to the parked state), the proposed EDBI encoding achieves lower bit-transition probability when compared to WC and DBI encoding, e.g., where WC or DBI performed on 4-bit data groups can result in a reduced bit-transition probability to about 0.44. Under the aforementioned assumption, bit-transition probability is about 0.5 when no bus encoding scheme is used at all.

Moreover, some embodiments are capable of determining the final value of the buses which collect data from multiple sources using an OR tree or daisy chain. For example, the EDBI logic 160 inverts bits to ensure that the combined data transition activity is as low as possible; whereas, other solutions (such as DBI or WC encoding) do not consider the final parked state, e.g., leading to an increase in data transition activity. Accordingly, some embodiments reduce power consumption of buses coupled with OR tree or daisy chain. In turn, the saved power budget can extend battery life of a computing system that includes such a bus and/or be used to improve performance.

Fig. 7 illustrates a block diagram of an embodiment of a computing system 700. One or more of the agents 102 of Fig. 1 may comprise one or more components of the computing system 700. Also, various components of the system 700 include logic 160 as illustrated in Fig. 7. However, logic 160 may be provided in locations throughout the system 700, including or excluding those illustrated. For example, logic 160 can be provided inside of memory 712 and at the interface of memory 712, or other blocks. Hence, logic 160 can be placed wherever data value(s) need to be parked. The computing system 700 includes one or more central processing unit(s) (CPUs) 702 (collectively referred to herein as "processors 702" or more generically "processor 702") coupled to an interconnection network (or bus) 704. The operations discussed with reference to Figs. 1-6 can be performed by one or more components of the system 700.

The processors 702 can be any type of processor such as a general purpose processor, a network processor (which processes data communicated over a computer network 705), etc. (including a reduced instruction set computer (RISC) processor or a complex instruction set computer (CISC)). Moreover, the processors 702 has a single or multiple core design. The processors 702 with a multiple core design integrate different types of processor cores on the same integrated circuit (IC) die. Also, the processors 702 with a multiple core design can be implemented as symmetrical or asymmetrical multiprocessors.

The processor 702 include one or more caches, which are private and/or shared in various embodiments. Generally, a cache stores data corresponding to original data stored elsewhere or computed earlier. To reduce memory access latency, once data is stored in a cache, future use can be made by accessing a cached copy rather than prefetching or recomputing the original data. The cache(s) can be any type of cache, such a level 1 (L1) cache, a level 2 (L2) cache, a level 3 (L3), a mid-level cache, a last level cache (LLC), etc. to store electronic data (e.g., including instructions) that is utilized by one or more components of the system 700. Additionally, such cache(s) can be located in various locations (e.g., inside other components to the computing systems discussed herein.

A chipset 706 can additionally be coupled to the interconnection network 704. Further, the chipset 706 includes a graphics memory control hub (GMCH) 708. The GMCH 708 includes a memory controller 710 that is coupled to a memory 712. The memory 712 stores data, e.g., including sequences of instructions that are executed by the processor 702, or any other device in communication with components of the computing system 700. Also, in one embodiment, the memory 712 includes one or more volatile storage (or memory) devices such as random access memory (RAM), dynamic RAM (DRAM), synchronous DRAM (SDRAM), static RAM (SRAM), etc. Nonvolatile memory can also be utilized such as a hard disk. Additional devices can be coupled to the interconnection network 704, such as multiple processors and/or multiple system memories.

The GMCH 708 further includes a graphics interface 714 coupled to a display device 716 (e.g., via a graphics accelerator in an embodiment). In one embodiment, the graphics interface 714 is coupled to the display device 716 via an Accelerated Graphics Port (AGP) or Peripheral Component Interconnect (PCI) (or PCI express (PCIe) interface). In an embodiment, the display device 716 (such as a flat panel display) is coupled to the graphics interface 714 through, for example, a signal converter that translates a digital representation of an image stored in a storage device such as video memory or system memory (e.g., memory 712) into display signals that are interpreted and displayed by the display 716.

As shown in Fig. 7, a hub interface 718 couples the GMCH 708 to an input/output control hub (ICH) 720. The ICH 720 provides an interface to input/output (I/O) devices coupled to the computing system 700. The ICH 720 is coupled to a bus 722 through a peripheral bridge (or controller) 724, such as a Peripheral Component Interconnect (PCI) bridge that is compliant with the PCIe specification, a Universal Serial Bus (USB) controller, I2C (Interface to Communicate), etc. The bridge 724 provides a data path between the processor 702 and peripheral devices. Other types of topologies can also be utilized. Additionally, multiple buses can be coupled to the ICH 720, e.g., through multiple bridges or controllers. Further, bus 722 can comprises other types and configurations of bus systems. Moreover, other peripherals coupled to the ICH 720 include, in various embodiments, integrated drive electronics (IDE) or small computer system interface (SCSI) hard drive(s), USB port(s), I2C device(s), a keyboard, a mouse, parallel port(s), serial port(s), floppy disk drive(s), digital output support (e.g., digital video interface (DVI)), etc.

The bus 722 is coupled to an audio device 726, one or more disk drive(s) 728, and a network adapter 730 (which is a NIC in an embodiment). In one embodiment, the network adapter 730 or other devices coupled to the bus 722 communicate with the chipset 706. Also, various components (such as the network adapter 730) are coupled to the GMCH 708 in some embodiments. In addition, the processor 702 and the GMCH 708 can be combined to form a single chip. In an embodiment, the memory controller 710 is provided in one or more of the CPUs 702. Further, in an embodiment, GMCH 708 and ICH 720 are combined into a Peripheral Control Hub (PCH).

Additionally, the computing system 700 includes volatile and/or nonvolatile memory (or storage). For example, nonvolatile memory includes one or more of the following: read-only memory (ROM), programmable ROM (PROM), erasable PROM (EPROM), electrically EPROM (EEPROM), a disk drive (e.g., 728), a floppy disk, a compact disk ROM (CD-ROM), a digital versatile disk (DVD), flash memory, a magneto-optical disk, or other types of nonvolatile machine-readable media capable of storing electronic data (e.g., including instructions).

The memory 712 includes one or more of the following in an embodiment: an operating system (O/S) 732, application 734, and/or device driver 736. The memory 712 can also include regions dedicated to Memory Mapped I/O (MMIO) operations. Programs and/or data stored in the memory 712 are swapped into the disk drive 728 as part of memory management operations. The application(s) 734 execute (e.g., on the processor(s) 702) to communicate one or more packets with one or more computing devices coupled to the network 705. In an embodiment, a packet is a sequence of one or more symbols and/or values that are encoded by one or more electrical signals transmitted from at least one sender to at least on receiver (e.g., over a network such as the network 705). For example, each packet has a header that includes various information which is utilized in routing and/or processing the packet, such as a source address, a destination address, packet type, etc. Each packet has a payload that includes the raw data (or content) the packet is transferring between various computing devices over a computer network (such as the network 705).

In an embodiment, the application 734 utilizes the O/S 732 to communicate with various components of the system 700, e.g., through the device driver 736. Hence, the device driver 736 includes network adapter 730 specific commands to provide a communication interface between the O/S 732 and the network adapter 730, or other I/O devices coupled to the system 700, e.g., via the chipset 706.

In an embodiment, the O/S 732 includes a network protocol stack. A protocol stack generally refers to a set of procedures or programs that is executed to process packets sent over a network 705, where the packets conform to a specified protocol. For example, TCP/IP (Transport Control Protocol/Internet Protocol) packets are processed using a TCP/IP stack. The device driver 736 indicates the buffers in the memory 712 that are to be processed, e.g., via the protocol stack.

The network 705 can include any type of computer network. The network adapter 730 can further include a direct memory access (DMA) engine, which writes packets to buffers (e.g., stored in the memory 712) assigned to available descriptors (e.g., stored in the memory 712) to transmit and/or receive data over the network 705. Additionally, the network adapter 730 includes a network adapter controller logic (such as one or more programmable processors) to perform adapter related operations. In an embodiment, the adapter controller is a MAC (media access control) component. The network adapter 730 further includes a memory, such as any type of volatile/nonvolatile memory (e.g., including one or more cache(s) and/or other memory types discussed with reference to memory 712).

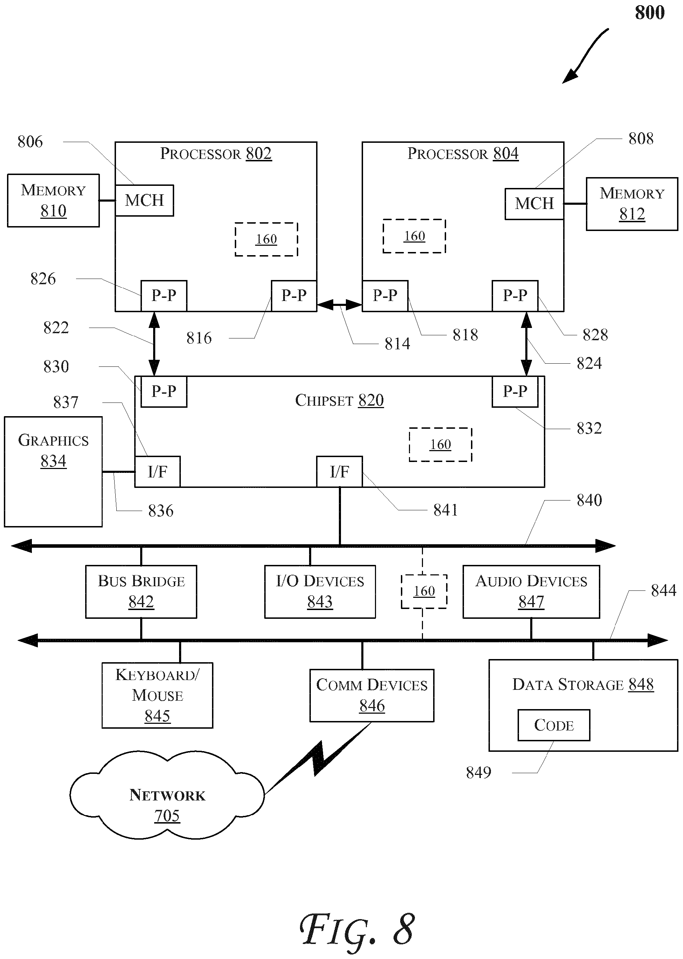

Fig. 8 illustrates a computing system 800 that is arranged in a point-to-point (PtP) configuration, according to an embodiment. In particular, Fig. 8 shows a system where processors, memory, and input/output devices are interconnected by a number of point-to-point interfaces. The operations discussed with reference to Figs. 1-7 can be performed by one or more components of the system 800.

As illustrated in Fig. 8, the system 800 includes several processors, of which only two, processors 802 and 804 are shown for clarity. The processors 802 and 804 each include a local Memory Controller Hub (MCH) 806 and 808 to enable communication with memories 810 and 812. The memories 810 and/or 812 store various data such as those discussed with reference to the memory 812 of Fig. 8. As shown in Fig. 8, the processors 802 and 804 (or other components of system 800 such as chipset 820, I/O devices 843, etc.) can also include one or more cache(s) such as those discussed with reference to Figs. 1-7.

In an embodiment, the processors 802 and 804 are one of the processors 802 discussed with reference to Fig. 8. The processors 802 and 804 exchange data via a point-to-point (PtP) interface 814 using PtP interface circuits 816 and 818, respectively. Also, the processors 802 and 804 can each exchange data with a chipset 820 via individual PtP interfaces 822 and 824 using point-to-point interface circuits 826, 828, 830, and 832. The chipset 820 can further exchange data with a high-performance graphics circuit 834 via a high-performance graphics interface 836, e.g., using a PtP interface circuit 837.

In at least one embodiment, logic 160 is provided in one or more of the processors 802, 804 and/or chipset 820. Other embodiments, however, may exist in other circuits, logic units, or devices within the system 800 of Fig. 8. Furthermore, other embodiments may be distributed throughout several circuits, logic units, or devices illustrated in Fig. 8. For example, various components of the system 800 include the logic 160 of Fig. 1. However, logic 160 can be provided in locations throughout the system 800, including or excluding those illustrated.

The chipset 820 communicates with the bus 840 using a PtP interface circuit 841. The bus 840 has one or more devices that communicate with it, such as a bus bridge 842 and I/O devices 843. Via a bus 844, the bus bridge 842 communicates with other devices such as a keyboard/mouse 845, communication devices 846 (such as modems, network interface devices, or other communication devices that communicate with the computer network 805), audio I/O device, and/or a data storage device 848. The data storage device 848 stores code 849 that is executed by the processors 802 and/or 804.

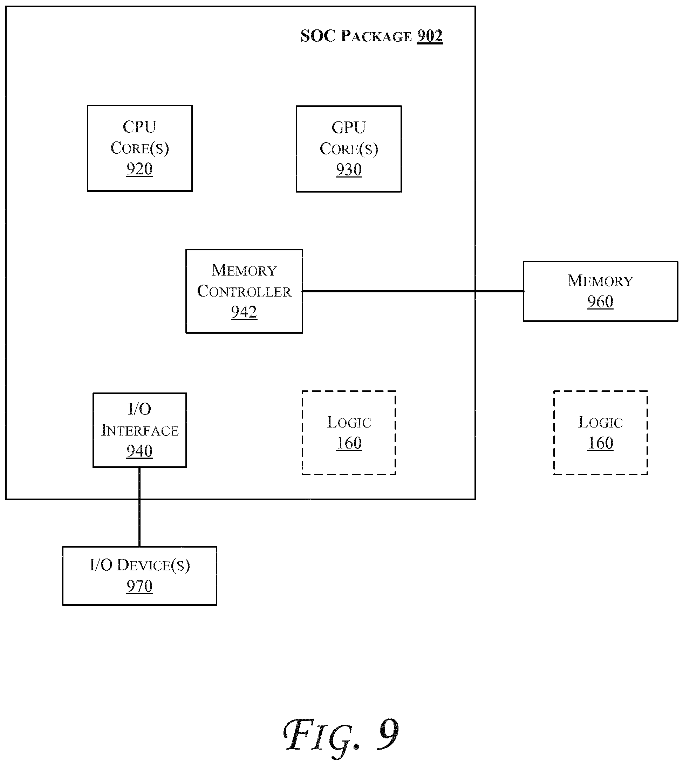

In some embodiments, one or more of the components discussed herein can be embodied as a System On Chip (SOC) device. Fig. 9 illustrates a block diagram of an SOC package in accordance with an embodiment. As illustrated in Fig. 9, SOC 902 includes one or more Central Processing Unit (CPU) cores 920, one or more Graphics Processor Unit (GPU) cores 930, an Input/Output (I/O) interface 940, and a memory controller 942. Various components of the SOC package 902 are coupled to an interconnect or bus such as discussed herein with reference to the other figures. Also, the SOC package 902 may include more or less components, such as those discussed herein with reference to the other figures. Further, each component of the SOC package 920 may include one or more other components, e.g., as discussed with reference to the other figures herein. In one embodiment, SOC package 902 (and its components) is provided on one or more Integrated Circuit (IC) die, e.g., which are packaged into a single semiconductor device.

As illustrated in Fig. 9, SOC package 902 is coupled to a memory 960 (which can be similar to or the same as memory discussed herein with reference to the other figures) via the memory controller 942. In an embodiment, the memory 960 (or a portion of it) can be integrated on the SOC package 902.

The I/O interface 940 is coupled to one or more I/O devices 970, e.g., via an interconnect and/or bus such as discussed herein with reference to other figures. I/O device(s) 970 include one or more of a keyboard, a mouse, a touchpad, a display, an image/video capture device (such as a camera or camcorder/video recorder), a touch screen, a speaker, or the like. Furthermore, SOC package 902 includes/integrates the logic 160 in an embodiment. Alternatively, the logic 160 is provided outside of the SOC package 902 (i.e., as a discrete logic).

In various embodiments, the operations discussed herein, e.g., with reference to Figs. 1-9, are implemented as hardware (e.g., circuitry), software, firmware, microcode, or combinations thereof, which can be provided as a computer program product, e.g., including a tangible (e.g., non-transitory) machine-readable or (e.g., non-transitory) computer-readable medium having stored thereon instructions (or software procedures) used to program a computer to perform a process discussed herein. Also, the term "logic" may include, by way of example, software, hardware, or combinations of software and hardware. The machine-readable medium may include a storage device such as those discussed with respect to Figs. 1-9. Additionally, such computer-readable media can be downloaded as a computer program product, wherein the program may be transferred from a remote computer (e.g., a server) to a requesting computer (e.g., a client) through data signals in a carrier wave or other propagation medium via a communication link (e.g., a bus, a modem, or a network connection).

Reference in the specification to "one embodiment" or "an embodiment" means that a particular feature, structure, or characteristic described in connection with the embodiment may be included in at least an implementation. The appearances of the phrase "in one embodiment" in various places in the specification may or may not be all referring to the same embodiment.

Also, in the description and claims, the terms "coupled" and "connected," along with their derivatives, may be used. In some embodiments, "connected" may be used to indicate that two or more elements are in direct physical or electrical contact with each other. "Coupled" may mean that two or more elements are in direct physical or electrical contact. However, "coupled" may also mean that two or more elements may not be in direct contact with each other, but may still cooperate or interact with each other.

Thus, although embodiments have been described in language specific to structural features and/or methodological acts, it is to be understood that claimed subject matter may not be limited to the specific features or acts described. Rather, the specific features and acts are disclosed as sample forms of implementing the claimed subject matter.

## Claims

1. An apparatus comprising:
a receiver to be coupled to a data bus, the receiver to receive incoming data;
control logic (600), coupled to the receiver, to determine whether a next data value on the data bus is going to transition from a valid value to a parked state; and
encode logic (160) to encode the incoming data based at least in part on the determination of whether the next data value on the bus is going to be transitioning from the valid value to the parked state,
wherein the encode logic is to encode the incoming data based at least in part on comparison of: a hamming distance between a present bus value and the next data value, and a weight of the next data value, and wherein the encode logic is to cause an inversion of the next data value at least in part based on comparison of a weight of the next data value and a width of the bus.

2. The apparatus of claim 1, wherein the incoming data is to originate from a plurality of sources, or wherein the plurality of sources are to comprise a plurality of buses, or wherein the plurality of sources are to be coupled in a daisy chain configuration, or wherein the plurality of sources are to be coupled in an OR tree configuration.

3. The apparatus of claim 1, wherein the encode logic is to encode the incoming data from the plurality of buses with an extra bit.

4. The apparatus of claim 1, wherein the encode logic, the control logic, a processor having one or more processor cores, and memory are on a same integrated device.

5. A method comprising:
encoding incoming data on a bus based at least in part on a determination of whether a next data value on the bus is going to be transitioning from a valid value to a parked state encoding the incoming data based at least in part on comparison of: a hamming distance between a present bus value and the next data value, and a weight of the next data value, and causing an inversion of the next data value at least in part based on comparison of a weight of the next data value and a width of the bus.

6. The method of claim 5, wherein the incoming data originates from a plurality of sources, or wherein the plurality of sources comprise a plurality of buses.

7. The method of claim 6, wherein the plurality of sources are coupled in a daisy chain configuration.

8. The method of claim 6, wherein the plurality of sources are coupled in an OR tree configuration.

9. The method of claim 5, further comprising encoding the incoming data from the plurality of buses with an extra bit.

10. An apparatus comprising means to perform a method as set forth in any preceding claim.

11. Machine-readable storage including machine-readable instructions, when executed, to implement a method or realize an apparatus as set forth in any preceding claim.

## Patentansprüche

1. Vorrichtung, umfassend:
einen Empfänger, um mit einem Datenbus gekoppelt zu werden, wobei der Empfänger eingehende Daten empfängt;
Steuerlogik (600), die mit dem Empfänger gekoppelt ist, um zu bestimmen, ob ein nächster Datenwert auf dem Datenbus von einem gültigen Wert in einen Parkzustand übergeht; und
Codierlogik (160) zum Codieren der eingehenden Daten wenigstens teilweise basierend auf der Bestimmung dessen, ob der nächste Datenwert auf dem Bus vom gültigen Wert in den Parkzustand übergeht,
wobei die Codierlogik zum Codieren der eingehenden Daten wenigstens teilweise basierend auf einem Vergleich ist von: einem Hamming-Abstand zwischen einem gegenwärtigen Buswert und dem nächsten Datenwert und einem Gewicht des nächsten Datenwerts, und wobei die Codierlogik zum Bewirken einer Inversion des nächsten Datenwerts wenigstens teilweise basierend auf dem Vergleich eines Gewichts des nächsten Datenwerts und einer Breite des Busses ist.

2. Vorrichtung nach Anspruch 1, wobei die eingehenden Daten zum Abgehen von einer Mehrzahl von Quellen sind, oder wobei die Mehrzahl von Quellen zum Umfassen einer Mehrzahl von Bussen ist, oder wobei die Mehrzahl von Quellen ist, um in einer Hintereinanderschaltungskonfiguration gekoppelt zu werden, oder wobei die Mehrzahl von Quellen ist, um in einer ODER-Baumkonfiguration gekoppelt zu werden.

3. Vorrichtung nach Anspruch 1, wobei die Codierlogik zum Codieren der eingehenden Daten von der Mehrzahl von Bussen mit einem zusätzlichen Bit ist.

4. Vorrichtung nach Anspruch 1, wobei die Codierlogik, die Steuerlogik, ein Prozessor mit einem oder mehreren Prozessorkernen und Speicher auf einer gleichen integrierten Vorrichtung sind.

5. Verfahren, umfassend:
Codieren von eingehenden Daten auf einem Bus wenigstens teilweise basierend auf einer Bestimmung dessen, ob ein nächster Datenwert auf dem Bus von einem gültigen Wert in einen Parkzustand übergeht, Codieren der eingehenden Daten wenigstens teilweise basierend auf einem Vergleich von: einem Hamming-Abstand zwischen einem gegenwärtigen Buswert und dem nächsten Datenwert und einem Gewicht des nächsten Datenwerts, und Bewirken einer Inversion des nächsten Datenwerts wenigstens teilweise basierend auf dem Vergleich eines Gewichts des nächsten Datenwerts und einer Breite des Busses.

6. Verfahren nach Anspruch 5, wobei die eingehenden Daten von einer Mehrzahl von Quellen abgehen, oder wobei die Mehrzahl von Quellen eine Mehrzahl von Bussen umfasst.

7. Verfahren nach Anspruch 6, wobei die Mehrzahl von Quellen in einer Hintereinanderschaltungskonfiguration gekoppelt wird.

8. Verfahren nach Anspruch 6, wobei die Mehrzahl von Quellen in einer ODER-Baumkonfiguration gekoppelt wird.

9. Verfahren nach Anspruch 5, ferner umfassend ein Codieren der eingehenden Daten von der Mehrzahl von Bussen mit einem zusätzlichen Bit.

10. Vorrichtung, umfassend Mittel zum Durchführen eines Verfahrens nach einem der vorhergehenden Ansprüche.

11. Maschinenlesbarer Speicher, der maschinenlesbare Anweisungen umfasst, die bei Ausführung zum Implementieren eines Verfahren oder Realisieren einer Vorrichtung nach einem der vorhergehenden Ansprüche sind.

## Revendications

1. Appareil comprenant :
un récepteur destiné à être couplé à un bus de données, le récepteur devant recevoir des données entrantes ;
une logique de commande (600), couplée au récepteur, pour déterminer qu'une valeur de données suivante sur le bus de données va passer ou non d'une valeur valable à un état de repos ; et
une logique de codage (160) pour coder les données entrantes en fonction au moins en partie de la détermination que la valeur de données suivante sur le bus va passer ou non de la valeur valable à l'état de repos,
dans lequel la logique de codage sert à coder les données entrantes en fonction au moins en partie d'une comparaison : d'une distance de Hamming entre une valeur de bus actuelle et la valeur de données suivante, et d'un poids de la valeur de données suivante, et dans lequel la logique de codage sert à inciter une inversion de la valeur de données suivante en fonction au moins en partie de la comparaison d'un poids de la valeur de données suivante et d'une largeur du bus.

2. Appareil selon la revendication 1, dans lequel les données entrantes sont destinées à provenir d'une pluralité de sources, ou dans lequel la pluralité de sources doit comprendre une pluralité de bus, ou dans lequel la pluralité de sources doit être couplée dans une configuration en guirlande, ou dans lequel la pluralité de sources doit être couplée dans une configuration d'arborescence OU.

3. Appareil selon la revendication 1, dans lequel la logique de codage sert à coder les données entrantes depuis la pluralité du bus avec un bit supplémentaire.

4. Appareil selon la revendication 1, dans lequel la logique de codage, la logique de commande, un processeur ayant un ou plusieurs coeurs de processeur, et une mémoire se trouvent sur un même dispositif intégré.

5. Procédé comprenant :
le codage de données entrantes sur un bus en fonction au moins en partie d'une détermination qu'une valeur de données suivante sur le bus va passer ou non d'une valeur valable à un état de repos, le codage des données entrantes en fonction au moins en partie d'une comparaison : d'une distance de Hamming entre une valeur de bus actuelle et la valeur de données suivante, et d'un poids de la valeur de données suivante, et l'incitation d'une inversion de la valeur de données suivante en fonction au moins en partie de la comparaison d'un poids de la valeur de données suivante et d'une largeur du bus.

6. Procédé selon la revendication 5, dans lequel les données entrantes proviennent d'une pluralité de sources, ou dans lequel la pluralité de sources comprend une pluralité de bus.

7. Procédé selon la revendication 6, dans lequel la pluralité de sources est couplée dans une configuration en guirlande.

8. Procédé selon la revendication 6, dans lequel la pluralité de sources est couplée dans une configuration d'arborescence OU.

9. Procédé selon la revendication 5, comprenant en outre le codage des données entrantes depuis la pluralité du bus avec un bit supplémentaire.

10. Appareil comprenant un moyen pour exécuter un procédé selon l'une quelconque des revendications précédentes.

11. Support de mémorisation lisible par machine comportant des instructions lisibles par machine qui, à leur exécution, mettent en oeuvre un procédé ou réalisent un appareil selon l'une quelconque des revendications précédentes.
